Europäisches Patentamt

European Patent Office

Office européen des brevets

(11) Veröffentlichungsnummer: **0 237 105**

**A2**

(12) # EUROPÄISCHE PATENTANMELDUNG

(21) Anmeldenummer: 87200315.7

(51) Int. Cl.⁴: **G01N 24/08**

(22) Anmeldetag: 25.02.87

(30) Priorität: 06.03.86 DE 3607341
17.05.86 DE 3616749

(43) Veröffentlichungstag der Anmeldung:
16.09.87 Patentblatt 87/38

(84) Benannte Vertragsstaaten:
BE DE FR GB IT NL SE

(71) Anmelder: **Philips Patentverwaltung GmbH
Wendenstrasse 35 Postfach 10 51 49
D-2000 Hamburg 1(DE)
DE**
Anmelder: **N.V. Philips' Gloeilampenfabrieken
Groenewoudseweg 1
NL-5621 BA Eindhoven(NL)
BE FR GB IT NL SE**

(72) Erfinder: **McKinnon, Grame Colin, Dr.
Höschgasse 62
CH-8008 Zürich(CH)**

(74) Vertreter: **Hartmann, Heinrich, Dipl.-Ing. et al
Philips Patentverwaltung GmbH
Wendenstrasse 35 Postfach 10 51 49
D-2000 Hamburg 1(DE)**

(54) **Verfahren zum Bestimmen der spektralen Verteilung der Kernmagnetisierung in einem begrenzten Volumenbereich.**

(57) Zur Vermeidung des störenden Einflusses des Zerfalls der Quermagnetisierung und/oder der Wirbelströme wird eine Sequenz mit wenigstens zwei Hochfrequenzimpulsen n mal wiederholt, wobei der Abstand von Sequenz zu Sequenz so verändert wird, daß sich auch die zeitliche Lage der von den Hochfrequenzimpulsen erzeugten Echosignale von Sequenz zu Sequenz ändert. Wird dabei von jedem Echosignal jeweils ein Abtastwert zur Fourier-Transformation herangezogen, der eine definierte Lage mit Bezug auf die jeweilige Sequenz aufweist, dann ergibt sich ein Frequenzspektrum, das gar nicht oder nur in geringerem Umfang von den erwähnten Störeinflüssen abhängt.

FIG. 3

## "Verfahren zum Bestimmen der spektralen Verteilung der Kernmagnetisierung in einem begrenzten Volumenbereich"

Die Erfindung betrifft Verfahren zum Bestimmen der spektralen Verteilung der Kernmagnetisierung in einem begrenzten Volumenbereich, wobei wenigstens eine Sequenz mit mindestens zwei Hochfrequenzimpulsen in Anwesenheit eines stationären homogenen Magnetfeldes auf einen Untersuchungsbereich einwirkt und wobei die im Volumenbereich erzeugten Echosignale in digitale Abtastwerte umgesetzt werden, wonach eine Fourier-Transformation durchgeführt wird.

Ein solches Verfahren, das sich insbesondere für die medizinische Diagnostik eignet, ist aus J.Magn.Reson., 56, (1984), Seiten 350 bis 354 bekannt. Dabei werden die bei der Abtastung eines einzelnen Echosignals auftretenden Abtastwerte einer Fourier-Transformation unterzogen, woraus sich das Frequenzspektrum bzw. die spektrale Verteilung der Kernmagnetisierung in dem Volumenbereich ergibt.

Es hat sich gezeigt, daß die Linien eines solchen Spektrums durch verschiedene Einflüsse verbreitert werden. Einer dieser störenden Einflüsse ist der Zerfall der Quermagnetisierung in dem angeregten Volumenbereich; je schneller die Quermagnetisierung zerfällt -d.h. je kleiner die Spin-Relaxationszeit T2 ist -desto stärker ist die Linienverbreiterung. Einen noch stärkeren Einfluß auf die Linienverbreiterung können in der Praxis die zeitlich veränderlichen Magnetfelder haben, die durch die beim Schalten von magnetischen Gradientenfeldern auftretenden Wirbelströme verursacht werden.

Aufgabe der vorliegenden Erfindung ist es, ein Verfahren der eingangs genannten Art so auszubilden, daß auch bei Vorhandensein der geschilderten Störeinflüsse die spektrale Verteilung der Kernmagnetisierung in dem begrenzten Volumenbereich bestimmt werden kann.

Diese Aufgabe wird erfindungsgemäß dadurch gelöst, daß jede Sequenz mehrfach wiederholt wird, wobei von Sequenz zu Sequenz die zeitliche Lage wenigstens eines Hochfrequenzimpulses geändert wird, so daß sich von Sequenz zu Sequenz die zeitliche Lage des Echosignals innerhalb der Sequenz verschiebt und daß aus jeder dieser Sequenzen ein Abtastwert zur Fouriertransformation herangezogen wird, der innerhalb der Sequenz eine bestimmte zeitliche Lage hat.

Bei der Erfindung werden also nicht die Abtastwerte eines einzigen Echosignals einer Fourier-Transformation unterzogen, sondern die aus den zeitlich gegeneinander versetzten Echosignalen abgeleiteten Abtastwerte, die innerhalb ihrer Sequenz jeweils die gleiche zeitliche Lage haben. Es läßt sich nämlich zeigen, daß das durch die Fourier-Transformation erhaltene Frequenzspektrum dem Frequenzspektrum entspricht, das sich ergeben würde, wenn der Störeinfluß nicht vorhanden wäre, wobei die einzelnen Spektralwerte mit einem Faktor multipliziert sind, der unter anderem davon abhängt, wie lange der jeweils wirksame Störeinfluß in der betreffenden Sequenz auf die Kernmagnetisierung eingewirkt hat. Diese Störeinflüsse auf das Frequenzspektrum können also nur dann ganz ausgeschaltet werden, wenn in jeder Sequenz bis zur Erfassung des Abtastwertes die Kernmagnetisierung demselben Störeinfluß unterworfen waren.

Wenn die Linienverbreiterung daher durch die sogenannte T2-Relaxation bedingt ist, die nach dem ersten Hochfrequenzimpuls einer Sequenz einsetzt, müssen die Abtastwerte, über die die Fourier-Transformation durchgeführt wird, alle den gleichen Abstand vom ersten Hochfrequenzimpuls ihrer Sequenz aufweisen. Wenn die Linienverbreiterung hingegen durch Wirbelstromeinflüsse verursacht wird, müssen die Abtastwerte jeweils den gleichen Abstand zu den Gradientenfeldern aufweisen, die die Wirbelströme hervorrufen. Da wegen des Abklingens der Wirbelstromeffekte der Einfluß eines magnetischen Gradientenfeldes um so größer ist, je geringer sein Abstand vom Echosignal ist, müßten die der Fourier-Transformation unterzogenen Abtastwerte den gleichen Abstand vom letzten Hochfrequenzimpuls haben -falls die magnetischen Gradientenfelder in fester zeitlicher Beziehung zu diesem letzten Hochfrequenzimpuls stehen.

In der Regel ist es daher nicht möglich, gleichzeitig den Einfluß der T2-Relaxation und der Wirbelströme auf die Linienbreite zu eliminieren. Jedoch können die Abtastwerte so gewählt werden, daß der Einfluß verringert wird.

An dieser Stelle sei erwähnt, daß bereits ein Verfahren zur Bestimmung des Spektrums von in Lösung befindlichen Molekülen bekannt ist, bei dem ebenfalls eine Anzahl von Sequenzen verwendet wird, bei denen die zeitliche Lage des Echosignals von Sequenz zu Sequenz variiert (vgl. J.Chem.Phys., Vol. 64, No. 10, 15. May 1976, Seiten 4226 und 4227). Die Abtastwerte der einzelnen Echosignale werden dabei einer zweidimensionalen Fourier-Transformation unterzogen. Die dabei zu untersuchenden Moleküle bestehen aus verschiedenen Gruppen, z.B. Methyl-, Methylen-und Hydroxyl-Gruppen, deren Protonen einerseits einer chemischen Verschiebung ausgesetzt sind und anderer seits aufgrund von Spin-Spin-Wechselwirkungen eine Multiplett-Struktur aufweisen. Dies hätte zur Folge, daß in einem eindimensionalen Frequenzspektrum eine Vielzahl von Linien enthalten wäre, die durch die zweidimensionale Fourier-Transformation in einem zweidimensionalen Spektrum verteilt werden, wobei das Spektrum in Richtung der einen Frequenzachse die von der Wechselwirkung unbeeinflußten Resonanzfrequenzen zeigt und in Richtung der anderen Frequenzachse ausschließlich die Multiplett-Aufspaltung.

Welche Art von Echosignalen benutzt wird, ist für die Erfindung nicht wichtig. Wesentlich ist nur, daß die zeitliche Lage des Echosignals durch Variieren der zeitlichen Lage der Hochfrequenzimpulse innerhalb einer Sequenz veränderbar ist. Vorzugsweise werden stimulierte Echosignale verarbeitet, jedoch können auch andere Echosignale, beispielsweise stimulierte Spin-Echosignale, ausgewertet werden.

Die Erfindung wird nachstehend anhand der Zeichnung näher erläutert. Es zeigen:

Fig. 1 ein Gerät für medizinische Kernspinuntersuchungen, mit dem das erfindungsgemäße Verfahren durchführbar ist,

Fig. 2 ein Blockschaltbild eines solchen Gerätes,

Fig. 3 den zeitlichen Verlauf verschiedener Signale bei einem erfindungsgemäßen Verfahren, und

Fig. 4 den zeitlichen Verlauf eines Teils dieser Signale bei einem bevorzugten Verfahren.

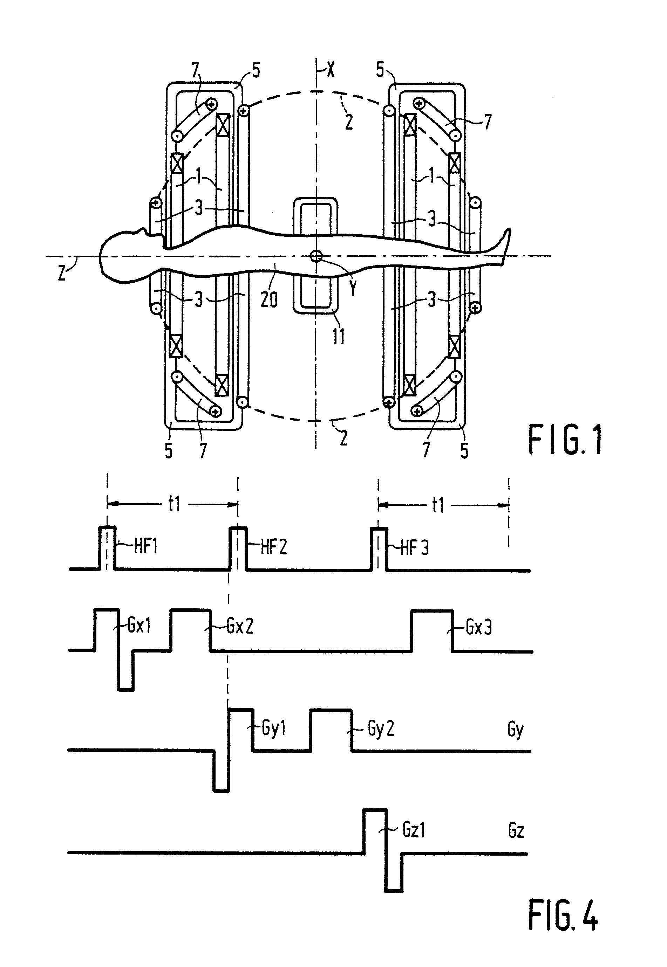

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = O des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. -Im Anschluß an drei Hochfrequenzimpulse dient die Hochfrequenzspule 11 zum Empfangen des im Untersuchungsbereich erzeugten Echosignals. Statt dessen kann aber auch eine gesonderte Hochfrequenz-Empfangsspule verwendet werden.

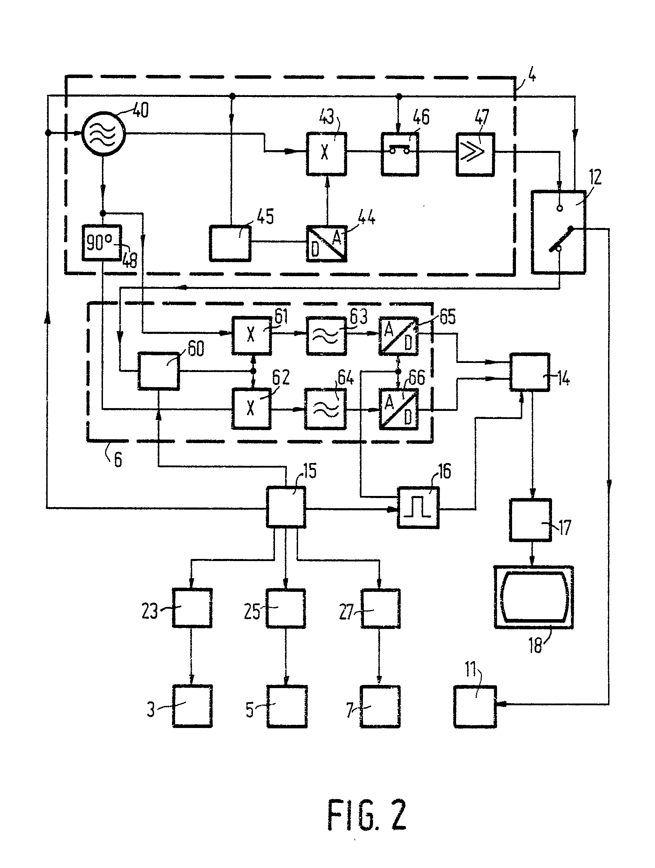

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 4O, der Schwingungen mit einer Frequenz gleich der Larmorfrequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 4O ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird -gesteuert durch eine Steuereinrichtung 15 -eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hoch frequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiPlikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner zugeführt, der daraus durch eine diskrete Fourier-Transformation die spektrale Verteilung der Kernmagnetisierung ermittelt und an einer geeigneten Wiedergabeeinheit, z.B. einem Monitor 18, ausgibt.

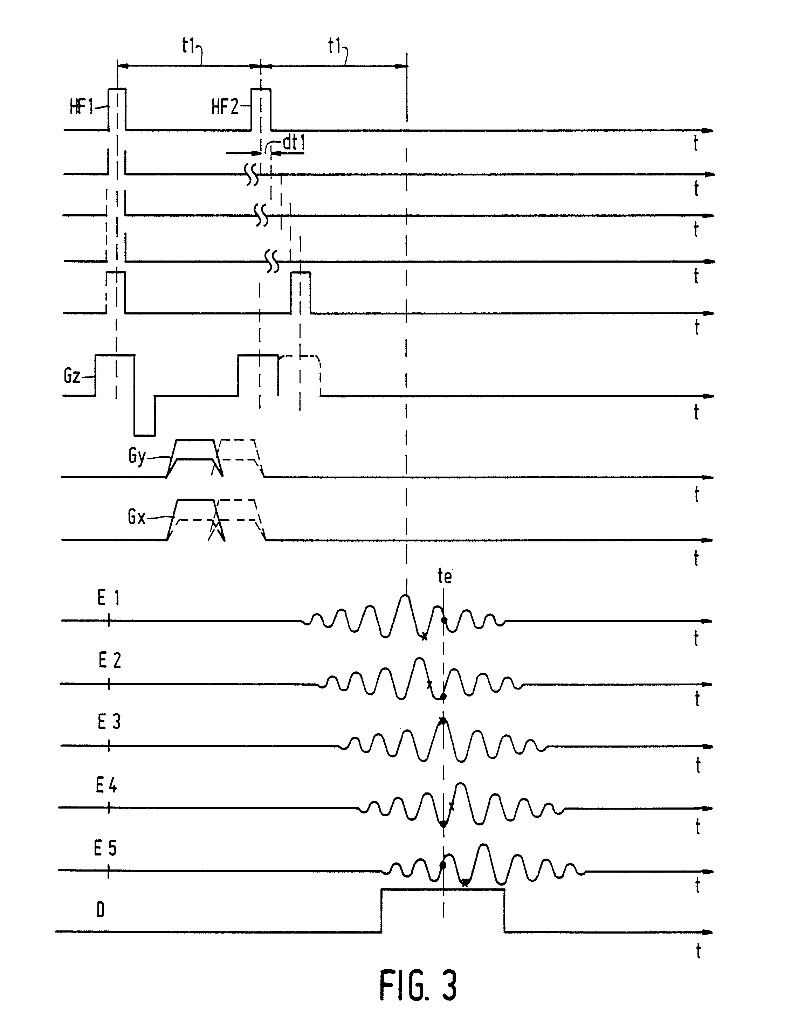

In Fig. 3 ist der zeitliche Verlauf von verschiedenen mit der Schaltung nach Fig. 2 empfangenen oder erzeugten Signalen für das erfindungsgemäße Verfahren dargestellt. Die erste Zeile zeigt den zeitlichen Verlauf des Ausgangssignals des Hochfrequenzerzeugers 4 bei einer ersten Frequenz. Dabei wird zunächst ein erster Hochfrequenzimpuls HF1, vorzugsweise ein 90°-Hochfrequenzimpuls, erzeugt und im zeitlichen Abstand t1 von dem ersten Hochfrequenzimpuls ein zweiter Hochfrequenzimpuls HF2, und zwar ein 180°-Impuls. Dadurch wird ein Echosignal E1 erzeugt, dessen zeitlicher Verlauf in der neunten Zeile dargestellt ist. Der zeitliche Abstand der Mitte dieses Hochfrequenzsignals von der Mitte des zweiten Hochfrequenzimpulses HF2 ist gleich dem zeitlichen Abstand t1 zwischen den Mitten des ersten und des zweiten Hochfrequenzimpulses.

Die zweite Sequenz, die in der zweiten Zeile nur schematisch angedeutet ist, unterscheidet sich von der ersten Sequenz dadurch, daß der zeitliche Abstand zwischen den Hochfrequenzimpulsen HF1 und HF2 um den Betrag dt1 vergrößert ist. Infolgedessen wächst der Abstand des durch diese Hochfrequenzimpulse erzeugten, in der zehnten Zeile dargestellten Echosignals E2 vom zweiten Hochfrequenzimpuls ebenfalls um den Betrag dt1 und vom ersten Hochfrequenzimpuls um den Betrag 2dt1. Die dritte Sequenz unterscheidet sich von der zweiten dadurch, daß der Abstand zwischen den zwei Hochfrequenzimpulsen (dritte Zeile) erneut um dt1 vergrößert ist, so daß der Abstand des Echosignals vom ersten bzw. vom zweiten Hochfrequenzimpuls erneut um dt1 bzw. 2dt1 vergrößert ist. Das gleiche gilt für die Hochfrequenzimpulse (vierte Zeile) und das Echosignal E4 (zwölfte Zeile) der vierten Sequenz im Hinblick auf die entsprechenden Signale in der dritten Sequenz und für die fünfte Sequenz im Hinblick auf die vierte Sequenz. Bei der fünften Sequenz ist daher der Abstand zwischen den beiden Hochfrequenzimpulsen (vgl. Zeile fünf von Fig. 3) um 4dt1 größer als t1 und der zeitliche Abstand zwischen dem daraus erzeugten Echosignal E5 (vgl. dreizehnte Zeile von Fig. 3) vom ersten bzw. vom zweiten Hochfrequenzimpuls um 8dt1 bzw. um 4dt1 größer als der entsprechende Abstand in der ersten Sequenz.

In der Praxis werden nicht nur fünf Sequenzen mit von Sequenz zu Sequenz vorzugsweise gleichmäßig verändertem Abstand zwischen den Hochfrequenzimpulsen durchgeführt, sondern n, wobei n z.B. 32, 64 oder 128 beträgt.

Jedes der bei den verschiedenen Sequenzen erzeugten Echosignale wird während eines Zeitraums von definierter Größe und definiertem Abstand vom ersten Hochfrequenzimuls abgetastet; in diesem Zeitraum wird der Taktgenerator 16 durch das Steuersignal D (Fig. 3 letzte Zeile) der Steuereinheit 15 freigegeben, so daß jeweils nur in diesen Zeiträumen die Ausgangssignale der Tiefpässe 63 und 64 von den Analog-Digital-Wandlern 65 und 66 in digitale Abtastwerte umgesetzt und in dem Speicher 14 gespeichert werden. Die Zeitintervalle, in denen jeweils die Abtastung der Echosignale erfolgt, müssen nicht notwendigerweise die gleiche Dauer und den gleichen Abstand vom ersten Hochfrequenzimpuls haben. Es genügt, wenn sie sich in wenigstens einem Zeitabschnitt überlappen.

Der Rechner 17 ist so programmiert, daß er die Abtastwerte, die zur Zeit t = te, d.h. im jeweils gleichen Abstand vom ersten Hochfrequenzimpuls erfaßt werden, einer Fourier-Transformation unterzieht. Es wird hierbei also nicht die Folge der Abtastwerte eines einzigen Echosignals einer Fourier-Transformation unterzogen, sondern diejenigen Abtastwerte verschiedener Echosignale, bei denen der Störeinfluß (im bisher beschriebenen Fall: der Zerfall der Quermagnetisierung) jeweils während des gleichen Zeitraums innerhalb der Sequenz wirksam war. Es läßt sich zeigen, daß das durch eine derartige Fourier-Transformation erhaltene Frequenzspektrum dem Frequenzspektrum entspricht, das sich ergeben würde, wenn der Störeinfluß nicht vorhanden wäre, wobei jede Komponente des Spektrums jedoch mit einem Faktor multiliziert ist, der u.a. von te abhängt. Infolgedessen wirkt sich der Störeinfluß nicht als Linienverbreiterung der erhaltenen Spektralkomponenten aus.

Wenn man von den einzelnen Echosignalen nicht den zum Zeitpunkt t = te, sondern einen zu einem anderen Zeitpunkt auftretenden Abtastwert der Fourier-Transformation unterziehen würde, dann müßte sich im Idealfall das gleiche Frequenzspektrum ergeben. Aufgrund unvermeidlicher Fehler bei der Meßwerterfassung und Verarbeitung ergeben sich jedoch Abweichungen, die dadurch verringert werden können, daß mehrere Folgen von Abtastwerten der Fourier-Transformation unterzogen werden, wobei jede Folge nur solche Abtastwerte umfaßt, die den gleichen zeitlichen Abstand vom ersten Hochfrequenzimpuls haben und daß die auf diese Weise erhaltenen geringfügig voneinander abweichenden Frequenzspektren addiert werden.

Vorstehend wurde davon ausgegangen, daß die Linienverbreiterung allein auf den zerfall der Kernmagnetisierung zurückzuführen ist. Jedoch können sich auch die durch das Ein-und Ausschalten von magnetischen Gradientenfeldern hervorgerufenen Wirbelströme ebenfalls in einer Verbreiterung der Spektrallinien bemerkbar machen -in der Praxis meist noch stärker als der Zerfall der Quermagnetierung. Wenn dieser Störeinfluß beseitigt werden soll, müssen diejenigen Abtastwerte zur Fourier-Transformation herangezogen werden, bei deren Erfassung der Untersuchungsbereich zumindest annähernd gleich lange dem Einfluß der Wirbelströme ausgesetzt war.

In den Zeilen sechs, sieben und acht ist der zeitliche Verlauf der von den Spulenanordnungen 3, 5 und 7 erzeugten magnetischen Gradientenfelder Gz, Gy und Gx dargestellt die die Wirbelströme hervorrufen. Während des ersten Hochfrequenzimpulses ist das magnetische Gradientenfeld Gz eingeschaltet, dessen Polarität nach dem Ende des Hochfrequenzimpulses umgekehrt wird, so daß das zeitliche Integral von der Mitte des Hochfrequenzimpulses bis zum Abschalten des Gradientenfeldes Gz Null wird. Dadurch wird die Kernmagnetisierung lediglich in einer zur z-Achse senkrechten Schicht angeregt. während des zweiten Hochfrequenzimpulses ist das magnetische Gradientenfeld Gz erneut eingeschaltet, und zwar während eines zu diesem Hochfrequenzimpuls symmetrischen Zeitraums, der sich von Sequenz zu Sequenz mit dem Hochfrequenzimpuls verschiebt, wie in der sechsten Zeile von Fig. 3 durch ausgezogene Linien (für die erste Sequenz) und gestrichelte Linien (für die fünfte Sequenz) angedeutet. Zwischen dem ersten und dem zweiten Einschalten des magnetischen Gradientenfeldes Gz werden auch die Gradientenfelder Gy und Gx während eines definierten Zeitintervalles eingeschaltet, und zwar so, daß der Abstand zum zweiten Hochfrequenzimpuls jeweils konstant bleibt, was in den Zeilen sieben und acht in Fig. 3 durch die ausgezogenen bzw. gestrichelten Linien zum Ausdruck gebracht ist. Das erstmalige Schalten des Gradientenfeldes Gz erfolgt also in fester zeitlicher Beziehung zum ersten Hochfrequenzimpuls, während das zweite Schalten des Gradientenfeldes Gz und das Schalten der Gradientenfelder Gy und Gx in fester zeitlicher Beziehung zum zweiten Hochfrequenzimpuls erfolgt.

Zur Fourier-Transformation werden nun die durch ein Kreuz markierten Abtastwerte der verschiedenen Echosignale E1...E5 herangezogen, die vom zweiten Hochfrequenzimpuls HF2 jeweils den gleichen Abstand haben (und deren Abstand vom ersten Hochfrequenzimpuls von Sequenz zu Sequenz um dt1 wächst). Bei dieser Lage der Abtastzeitpunkte wirken die Wirbelströme, die durch das Schalten des zum zweiten Hochfrequenzimpuls symmetrischen magnetischen Gradientenfeldes und der Gradientenfelder Gy und Gx hervorgerufen werden, innerhalb der Sequenz gleich lange ein, so daß sie keine Linienverbreiterung des durch die Fourier-Transformation erhaltenen Frequenzspektrums bewirken können. Dies gilt zwar nicht für die Wirbelströme, die beim erstmaligen in fester zeitlicher Beziehung zum ersten Hochfrequenzimpuls erfolgenden Schalten des Gradientenfeldes Gz auftreten, doch bleibt deren Einfluß wegen des exponentiellen Abklingens und dem relativ großen zeitlichen Abstand zum Echosignal gering.

Auch in diesem Fall ist es möglich, wie oben beschrieben, die Fourier-Transformation über weitere Folgen von Abtastwerten zu wiederholen und die Ergebnisse zu summieren.

Aus dem vorstehenden ergibt sich, daß es bei der angegebenen Spin-Echo-Sequenz nicht möglich ist, ein Fourier-Spektrum zu erzeugen, das gleichzeitig von den störenden Einflüssen der Wirbelströme und des Zerfalls der Quermagnetisierung befreit ist. Es ist jedoch möglich, die Auswirkungen beider Störeinflüsse auf die Linienbreite zu verringern, indem Abtastwerte herangezogen werden, die zwischen dem Zeitpunkt te und den angekreuzten Abtastzeitpunkten erfaßt worden sind.

Mit dem in Fig. 3 beschriebenen Verfahren kann die spektrale Verteilung in den Volumenelementen einer Schicht erfaßt werden. Dazu werden zunächst, wie schon beschrieben, n Sequenzen durchgeführt, wobei von Sequenz zu Sequenz der Abstand zwischen den Hochfrequenzimpulsen variiert wird. Dann wird dieses Verfahren p mal wiederholt, wobei jedesmal der Gradient Gy um einen kleinen Betrag geändert wird. All dies wird dann noch m mal wiederholt, wobei jedesmal der Gradient Gx um einen kleinen Betrag geändert wird. Die dabei erhaltene Datenmenge wird einer dreifachen diskreten Fourier-Transformation unterzogen, wobei sich für m,p-Volumenelemente in der Schicht jeweils ein Frequenzspektrum ergibt.

Es leuchtet ein, daß ein solches Verfahren außerordentlich zeitaufwendig ist. In der Regel ist für diagnostische Zwecke auch nur die Kenntnis der spektralen Verteilung in einem oder wenigen begrenzten Volumenelementen erforderlich.

In Fig. 4 ist eine Sequenz dargestellt, die sich besonders zur Ermittlung der spektralen Verteilung der Kernmagnetisierung in einem begrenzten Volumenbereich eignet. Jede Sequenz umfaßt drei Hochfrequenzimpulse, die vorzugsweise 90°-Hochfreguenzimpulse sind. Während des ersten Hochfrequenzimpulses wird ein magnetisches Gradientenfeld Gx1 mit einem Gradienten in x-Richtung eingeschaltet, während des zweiten Hochfrequenzimpulses ein magnetisches Gradientenfeld Gy1 mit einem Gradienten in y-Richtung und während des dritten Hochfrequenzimulses ein Gradientenfeld Gz1 mit einem Gradienten in z-Richtung. Der zeitliche Verlauf der magnetischen Gradientenfelder Gx1 und Gz1 ist so gewählt, daß der Gradient während des zugehörigen Hochfrequenzimpulses konstant ist und anschließend seine Richtung umkehrt und danach abgeschaltet wird, so daß das Integral über den Gradienten von der Mitte des Hochfrequenzimpulses HF1 bzw. HF3 bis zum Abschalten des Gradientenfeldes Gx1 bzw. Gy1 Null ist.

Würde die Schichtanregung durch den zweiten Hochfrequenzimpuls HF2 auf analoge Weise erfolgen wie beim ersten bzw. dritten Hochfrequenzimpuls Hf1 bzw. HF3, indem also während des Hochfrequenzimpulses das in y-Richtung verlaufende Gradientenfeld Gy eingeschaltet und anschließend umgeschaltet würde, dann wäre die Kernmagnetisierung in dem Schnittbereich der durch die drei Hochfrequenzimpulse angeregten Schichten zum Teil dephasiert. Dies würde dazu führen, daß sich beim Empfang des aus diesem Bereich kommenden Kernspin-Resonanzsignals ein verschlechtertes Signal-Rausch-Verhältnis ergeben würde. Diese Verschlechterung wird dadurch vermieden, daß, wie aus Fig. 4 ersichtlich, vor dem zweiten Hochfrequenzimpuls HF2 das magne tische Gradientenfeld Gy1 eingeschaltet wird, wodurch die Kernmagnetisierung in der durch den ersten Hochfrequenzimpuls angeregten und zur x-Achse senkrechten Schicht in y-Richtung dephasiert wird. Dadurch, daß die Polarität dieses Gradientenfeldes umgeschaltet wird, so daß dieses Gradientenfeld während des zweiten Hochfrequenzimpulses die entgegengesetzte Polarität hat wie unmittelbar zuvor, und dadurch, daß der zeitliche Verlauf des magnetischen Gradientenfeldes so gewählt ist, daß das zeitliche Integral über dieses Feld von dem Einschalten bis zur Mitte des zweiten Hochfrequenzimpulses Null ist, wird diese Dephasierung jedoch weitgehend beseitigt. Es wurde nämlich gefunden, daß der erste und der dritte Hochfrequenzimpuls den Vektor der Kernmagnetisierung von der longitudinalen, d.h. der z-Richtung, in die transversale Richtung (d.h. in die xy-Ebene) kippen, während der zweite Impuls spiegelbildlich dazu die Kernmagnetisierung von der transversalen in die longitudinale Richtung kippt. Deshalb muß der zweite Impuls das ihn begleitende magnetische Gradientenfeld in zeitlicher Hinsicht das Spiegelbild des ersten bzw. des dritten Hochfrequenzimpulses mit dem jeweils begleitenden magnetischen Gradientenfeld sein. Dies wird durch den in Fig. 2 angegebenen zeitlichen Verlauf sichergestellt.

Durch die drei Hochfrequenzimpulse in Verbindung mit den Gradientenfeldern wird die Kernmagnetisierung in drei zueinander senkrechten Schichten angeregt. Die Dicke dieser Schichten hängt von der Bandbreite der Hochfrequenzimpulse ab, die ihrerseits durch das im Speicher 45 gespeicherte Hüllkurvensignal bestimmt wird sowie von der Größe des Gradienten der Gradientenfelder Gx1, Gy1 bzw. Gz1.

Im Schnittbereich dieser drei Schichten entsteht u.a. ein stimuliertes Echosignal. Alle anderen Kernspin-Resonanzsignale, die in diesem Bereich - oder außerhalb -entstehen, werden durch Gradientenfelder Gx2, Gx3 sowie Gy2 unterdrückt. Das Gradientenfeld Gx2, das zeitlich zwischen den Gradientenfeldern Gx1 und Gy1 eingeschaltet wird, und das Gradientenfeld Gx3, das nach dem Gradientenfeld Gz1 und vor dem Abtasten des Echosignals eingeschaltet wird, haben einen solchen zeitlichen Verlauf, daß das zeitliche Integral über den Gradienten in beiden Fällen gleich ist und einen solchen Wert hat, daß die Kernmagnetisierung in der zur x-Achse senkrechten Schicht dephasiert werden könnte, wenn nur eines der Gradientenfelder wirksam wäre. Das magnetische Gradientenfeld Gy2, dessen Gradient senkrecht zu den Gradienten der Gradientenfelder Gx2 bzw. Gx3 verläuft, liegt zeitlich zwischen den Gradientenfeldern Gy1 und Gz1. Das zeitliche Integral darüber entspricht dem entsprechenden Integralwert über die Felder Gx2 bzw. Gx3.

Der zeitliche Abstand des stimulierten Echosignals, das durch die in Fig. 4 dargestellte Sequenz erzeugt wird, von dem dritten Hochfrequenzimpuls entsricht dem zeitlichen Abstand t1 zwischen dem ersten und dem zweiten Hochfrequenzimpuls. Die Lage des stimulierten Echosignals kann also beispielsweise dadurch verändert werden, daß die Lage des zweiten Hochfrequenzimpulses in bezug auf den ersten oder den dritten Hochfrequenzimpuls variiert wird. Wenn dabei der Abstand der magnetischen Gradientenfelder Gx2 und Gy2 vom ersten bzw. vom dritten Hochfrequenzimpuls beibehalten wird, haben die Abtastwerte des stimulierten Echosignals, die jeweils im gleichen Abstand von dem ersten bzw. dem dritten Hochfrequenzimpuls HF1 bzw. HF3 erfaßt werden, auch den gleichen zeitlichen Abstand von den magnetischen Gradientenfeldern Gx1, Gx2, Gx3, Gy2 und Gz1. Infolgedessen sind die Wirbelströme der genannten Gradientenfelder und der Zerfall der Quermagnetisierung für jeden Abtastwert gleich lange wirksam. Sie bewirken daher keine Linienverbreiterung. Lediglich die Wirbelströme des zeitlich mit dem zweiten Hochfrequenzimpuls HF2 gekoppelten magnetischen Gradientenfeldes GY1 können daher noch eine Linienverbreiterung bewirken.

Bei der in Fig. 4 dargestellten Sequenz ist es jedoch auch möglich, den Abstand zwischen der zweiten und der dritten Hochfrequenzimpuls konstant zu lassen und nur deren Abstand zum ersten Hochfrequenzimpuls zu variieren. Wenn dann die magnetischen Gradientenfelder Gx2, Gy2 und Gx3 ihre zeitliche Lage in bezug auf den zweiten und den dritten Hochfrequenzimpuls bei allen Sequenzen beibehalten, haben die durch das Schalten dieser magnetischen Gradientenfelder und der Gradientenfelder Gy1 und Gz1 hervorgerufenen Wirbelströme keinen Einfluß auf das durch Fourier-Transformation ermittelte Spektrum, wenn der Fourier-Transformation immer solche Abtastwerte zugrunde gelegt werden, die den gleichen zeitlichen Abstand vom zweiten bzw. vom dritten Hochfrequenzipuls aufweisen. In diesem Fall können sich nur noch der Zerfall der Quermagnetisierung und die mit dem magnetischen Gradientenfeld Gx1 verbundenen Wirbelströme störend auswirken, doch ist deren Einfluß auf das Frequenzspektrum geringer als in dem zuvor erwähnten Fall, weil der zeitliche Abstand zwischen dem stimulierten Echosignal und Gx1 größer ist als der Abstand dieses Echosignals von Gy1. Der Einfluß der Wirbelströme auf die Breite der Resonanzlinien des Spektrums ist dabei also noch weiter verringert, weshalb dieses Verfahren von besonderem Vorteil ist, wenn der Einfluß der mit dem zweiten und dritten Hochfrequenzimpuls verknüpften Wirbelströme auf die Linienverbreiterung relativ stark ist.

**Ansprüche**

1. Verfahren zum Bestimmen der spektralen Verteilung der Kernmagnetisierung in einem begrenzten Volumenbereich, wobei wenigstens eine Sequenz mit mindestens zwei Hochfrequenzimpulsen in Anwesenheit eines stationären homogenen Magnetfeldes auf einen Untersuchungsbereich einwirkt und wobei die im Volumenbereich erzeugten Echosignale in digitale Abtastwerte umgesetzt werden, wonach eine Fourier-Transformation durchgeführt wird,

dadurch gekennzeichnet , daß jede Sequenz mehrfach wiederholt wird, wobei von Sequenz zu Sequenz die zeitliche Lage wenigstens eines Hochfrequenzimpulses (z.B. HF2) geändert wird, so daß sich von Sequenz zu Sequenz die zeitliche Lage des Echosignals (E1...E5) innerhalb der Sequenz verschiebt und daß aus jeder dieser Sequenzen ein Abtastwert zur Fouriertransformation herangezogen wird, der innerhalb der Sequenz eine bestimmte zeitliche Lage hat.

2. Verfahren nach Anspruch 1, dadurch gekennzeichnet, daß jede Sequenz zur Erzeugung eines Spin-Echo-Signals einen ersten Hochfrequenzimpuls (HF1), vorzugsweise einen 90°-Hochfrequenzimpuls und darauffolgend einen 180°-Hochfrequenzimpuls (HF2) umfaßt.

3. Verfahren nach Anspruch 1, dadurch gekennzeichnet, daß jede Sequenz zur Erzeugung eines stimulierten Echosignals drei Hochfrequenzimpulse (HF1, HF2, HF3), vorzugsweise drei 90°-Hochfrequenzimpulse, umfaßt.

4. Verfahren nach Anspruch 1, dadurch gekennzeichnet, daß die Polarität des während des ersten bzw. des dritten Hochfrequenzimpulses (HF1 bzw. HF3) wirksamen magnetischen Gradientenfeldes (Gx1 bzw. Gz1) nach dem ersten bzw. dem dritten Hochfrequenzimpuls umgeschaltet wird, daß vor den zweiten Hochfrequenzimpuls (HF2) das magnetische Gradientenfeld (Gy1) mit einer zur Polarität dieses Feldes während des zweiten Hochfrequenzimpulses entgegengesetzten Polarität eingeschaltet wird, und daß der zeitliche Verlauf jedes der während eines Hochfrequenzimpulses wirksamen Gradientenfelder so gewählt ist, daß das zeitliche Integral von der Mitte des ersten bzw. des dritten Hochfrequenzimpulses bis zum Abschalten des jeweiligen Gradientenfeldes bzw. vom Einschalten des Gradientenfeldes bis zur Mitte des zweiten Hochfrequenzimpulses Null ist.

5. Verfahren nach Anspruch 3 oder 4, dadurch gekennzeichnet, daß in den verschiedenen Sequenzen der erste und der dritte Hochfrequenzimpuls den gleichen zeitlichen Abstand voneinander haben und daß die zeitliche Lage des zweiten Hochfrequenzimpulses in bezug auf den ersten bzw. den dritten Hochfrequenzimpuls von Sequenz zu Sequenz geändert wird.

6. Verfahren nach einem der Ansprüche 1 bis 3, dadurch gekennzeichnet , daß jeweils die Abtastwerte aus verschiedenen Sequenzen einer Fourier-Transformation unterzogen werden, die vom ersten Hochfrequenzimpuls (HF1) der Sequenz jeweils den gleichen zeitlichen Abstand (te) haben.

7. Verfahren nach Anspruch 2, dadurch gekennzeichnet, daß in allen Sequenzen in fester zeitlicher Beziehung zum 180°-Impuls magnetische Gradientenfelder ein-bzw. ausgeschaltet werden und daß jeweils diejenigen Abtastwerte aus verschiedenen Sequenzen einer Fourier-Transformation unterzogen werden, die von dem 180°-Hochfrequenzimpuls den gleichen zeitlichen Abstand haben.

8. Verfahren nach Anspruch 3, dadurch gekennzeichnet, daß in allen Sequenzen der zweite und dritte Hochfrequenzimpuls (HF2, HF3) voneinander den gleichen zeitlichen Abstand haben, daß ihr Abstand vom ersten Hochfrequenzimpuls von Sequenz zu Sequenz variiert wird, daß die magnetischen Gradientenfelder, ggf. bis auf ein mit dem ersten Hochfrequenzimpuls (HF1) einhergehendes magnetisches Gradientenfeld (Gx1), in allen Sequenzen die gleiche zeitliche Lage in bezug auf den zweiten und dritten Hochfrequenzimpuls haben und daß jeweils die Abtastwerte aus den verschiedenen Sequenzen einer einer Fourier-Transformation unterzogen werden, die von dem zweiten bzw. dem dritten Hochfrequenzimpuls den gleichen zeitlichen Abstand haben.

9. Verfahren nach einem der vorhergehenden Ansprüche, dadurch gekennzeichnet, daß mehrere Folgen von Abtastwerten einer Fourier-Transformation unterzogen werden, wobei die Abtastwerte einer Folge jeweils den gleichen zeitlichen Abstand von einem der Hochfrequenzimpulse der jeweiligen Sequenz aufweisen und daß die daraus resultierenden spektralen Verteilungen addiert werden.

10. Anordnung zur Durchführung des Verfahrens nach Anspruch 1 mit einem Magneten zur Erzeugung eines homogenen stationären Magnetfeldes, einer Hochfrequenz-Spulenanordnung zur Erzeugung eines hochfrequenten, zum stationären Magnetfeld senkrechten Magnetfeldes, einem Hochfrequenzgenerator zur Speisung der Hochfrequenz-Spulenanordnung, einer Steuereinheit zur Steuerung des Hochfrequenzgenerators und mit einer Recheneinheit zur Verarbeitung von Kernspin-Resonanzsignalen, dadurch gekennzeichnet, daß die Steuereinheit so ausgebildet ist, daß in jeder Sequenz wenigstens zwei Hochfrequenzimpulse erzeugt werden, deren Abstand von Sequenz zu Sequenz variiert und daß die Recheneinheit so ausgebildet ist, daß sie eine Fourier-Transformation mit Abtastwerten der Echosignale aus aufeinanderfolgenden Sequenzen durchführt.

FIG.1

FIG.4

FIG. 2

FIG. 3